# EUROPEAN PATENT APPLICATION

(11) **EP 0 887 842 A1**
(43) Date of publication of application: **30.12.1998**
(21) Application number: 98304768.9
(22) Date of filing: 17.06.1998
(51) Int. Cl.: H01L 21/28, H01L 21/336, H01L 21/8238, H01L 29/51

(54) **Field effect devices with improved gate insulator and method of manufacturing the same**

(30) Priority: 25.06.1997 US 881994
(71) Applicant: LUCENT TECHNOLOGIES INC., Murray Hill, New Jersey 07974-0636 (US)
(72) Inventor: Ma, Yi, Orlando, Florida 32837 (US); Roy, Pradip Kumar, Orlando, Florida 32819 (US)
(74) Representative: Watts, Christopher Malcolm Kelway, Dr.

(57) **Abstract**

In accordance with the invention, the gate oxide of a field effect device is provided with nitrogen doping selectively at the dielectric/source and dielectric/drain interfaces. The nitrogen doping forms thin, damage-resistant regions of oxynitride at these interfaces, thereby enhancing device reliability and lifetime. The nitrogen doping is preferably accomplished by implanting nitrogen into the source/drain area at a tilt angle and thermally annealing the resulting structure. During annealing the implanted nitrogen segregates to the semiconductor/dielectric interface and forms protective, oxynitride.

## Description

### Field Of The Invention

This invention relates to field effect devices employing improved thin film dielectrics and to methods for making such devices.

### Background Of The Invention

Field effect devices, such as field effect transistors, are fundamental components in modern electronics. They are basic components in most digital and many analog circuits, including circuits for data processing and telecommunications. Indeed it has been surmised that field effect transistors are among the most numerous of human-made objects.

Field effect devices typically comprise a controllable-conductivity path, called a channel, disposed between a source and a drain. A gate electrode is formed on a thin dielectric film overlying the channel. For example, the source and the drain can be n-type regions of silicon and the channel can be a p-type region connecting them. The gate electrode can be a conductively-doped polysilicon layer formed on a thin layer of silicon oxide overlying the channel.

In a normally off transistor, if no voltage is applied to the gate, current cannot flow from the source to the channel or from the channel to the drain. However if a sufficient positive voltage is applied to the gate, electrons are induced into the channel region, thereby creating a continuous n-type conductive path between the source and the drain.

One problem that has arisen as these devices are made with smaller dimensions is the effect of electrons on the gate dielectric layer. When the device is turned on, electrons from the source accelerate through the channel. They can collide with the gate dielectric, particularly near the dielectric/drain interface. Such collisions damage the dielectric and thereby reduce the reliability and operating life of the device.

The conventional approach to mitigating this problem is by implanting a low concentration of n or p-type dopants (depending on device type) into the source and drain regions near their respective interfaces with the dielectric. This implantation, referred to as the lightly doped drain process (LDD process), extends the source and the drain, forming a shallow junction under the dielectric interface. The junction forms a. local electrical field which slows electrons down before they reach the drain area and thus reduces damage to the dielectric.

While the LDD process reduces damage, it may not provide adequate protection in new processes with reduced device dimensions. Accordingly there is a need for an improved method for protecting gate dielectrics from electron damage.

### Summary Of The Invention

In accordance with the invention, the gate oxide of a field effect device is provided with nitrogen doping selectively at the dielectric/source and dielectric/drain interfaces. The nitrogen doping forms thin, damage-resistant regions of oxynitride at these interfaces, thereby enhancing device reliability and lifetime. The nitrogen doping is preferably accomplished by implanting nitrogen into the source/drain area at a tilt angle and thermally annealing the resulting structure. During annealing the implanted nitrogen segregates to the semiconductor/dielectric interface and forms a local protective oxynitride layer in the region of the interface.

### Brief Description Of The Drawings

The advantages, nature and various additional features of the invention will appear more fully upon consideration of the illustrative embodiments now to be described in detail. In the accompanying drawings:
Fig. 1 is a flow diagram showing the steps of the preferred method for making a field effect device having an improved gate dielectric;
Fig. 2 illustrates an appropriate workpiece and the implantation of nitrogen into it;
Fig. 3 is a schematic top view of the workpiece illustrating the horizontal components of the N implant vectors in relation to the gate.
Fig. 4 is a schematic cross section of an improved device made by the process of Fig. 1.

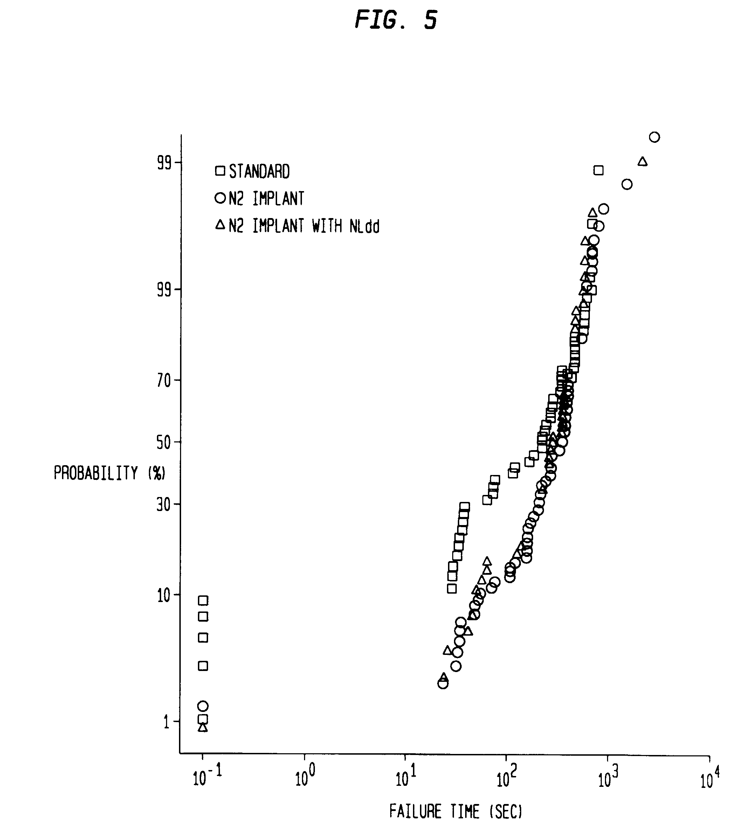

Figs. 5 is a graph of time-dependent electrical breakdown measurements on wafers with 50 angstrom gate oxides.

It is to be understood that these drawings are for purposes of illustrating the concepts of the invention and, except for graphs, are not to scale.

### Detailed Description

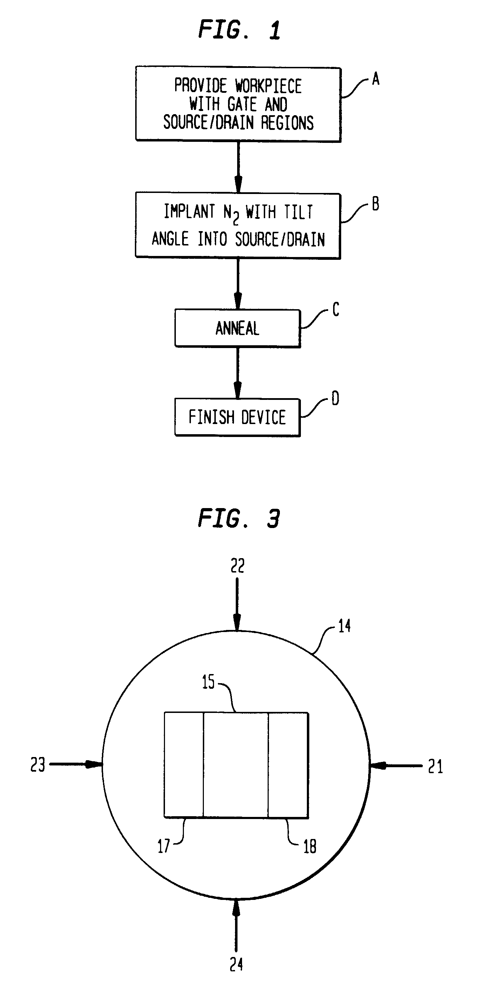

Referring to the drawings, Fig. 1 illustrates the steps in making a field effect device having an improved gate dielectric. As shown in block A of Fig. 1, the first step is to provide a workpiece having a gate, a gate dielectric and source and drain regions. Such a workpiece can be provided as an intermediate in the conventional fabrication of an integrated circuit such as described, for example, in S.J. Hillenius et al, "A Symmetric Sub-Micron CMOS Technology", IEDM Tech. Digest, 252 (1986) which is incorporated herein by reference.

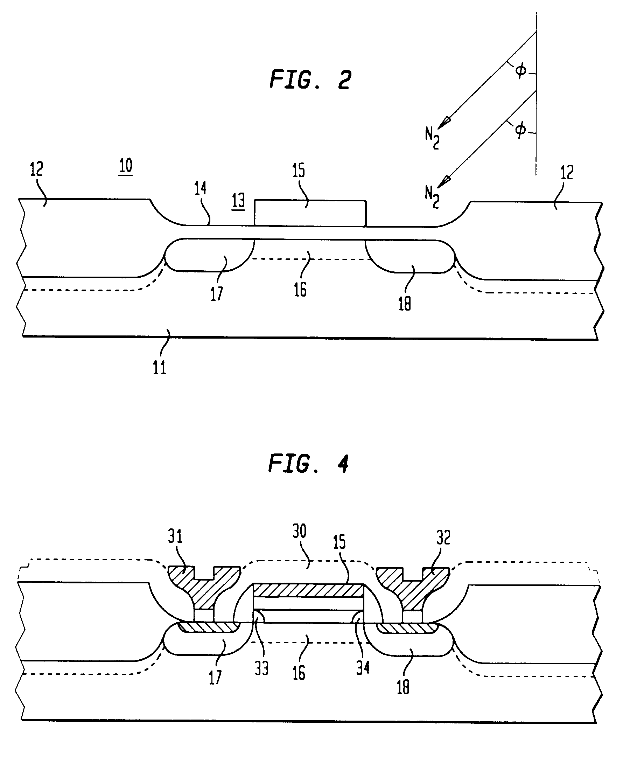

Fig. 2 schematically illustrates the features of a suitable workpiece 10 which essentially comprises a semiconductor substrate 11 having a major surface covered with passivating dielectric 12. An opening 13 has been made in the dielectric in the region where the transistor is to be formed. In the opening a thin dielectric film 14 covers the semiconductor and a gate electrode 15 has been patterned on the film 14. The region 16 underlying the gate is to become the channel of the transistor and the source region 17 and drain region 18 lie on either side of the channel. The dielectric film 14 typically has a thickness of less than 80 angstroms. The gate electrode 15 is typically a thin layer of polycrystalline silicon which, with subsequent doping, will exhibit conductivity. The source and drain regions will subsequent doping will become the source and drain of the transistor.

The next step shown in block B is to implant nitrogen into the source and drain regions 17, 18 at a tilt angle φ preferably in the range 7° - 45°. This step is schematically illustrated by the arrows in Fig. 2. Typical implantation is at energy in the range 5 KeV-100 KeV with a dose in the range 10¹³-10¹⁵/cm². The preferred implant is 25 KeV with a dose of 10¹⁴/cm² at a tilt angle of 7°.

The nitrogen implant is preferably directed toward each edge of the gate.. Advantageously it is carried out in four successive implantations with the wafer rotated by 90° between successive implants. Fig. 3 is a schematic top view illustrating the horizontal components 21, 22, 23, 24 of the N implant vectors in relation to the gate electrode 15.

The third step (block C) is to thermally anneal the workpiece following implantation. This is preferably done either in an inert gas such as nitrogen, argon or helium or in a mixture of oxygen with inert gas. Typical annealing is in N₂ at 800°C - 1000°C for 10-60 min. The preferred annealing is at 900°C for 30 min. The result of the thermal annealing is that implant damage is removed and the implanted nitrogen segregates to the interfaces and forms a protective layer of oxynitride near the dielectric/source and dielectric/drain interfaces. The oxynitride layer has a thickness of 3-5 angstroms and extends in both lateral directions from each interface. The width at. each interface is in the range 50-500 angstroms, depending on implant conditions.

The final step shown in block D is to finish the field effect device in the conventional manner, providing contacts to the source, gate and drain. This typically involves a lightly doped drain implant, depositing SiO₂ with LPCVD TEOS and etching back to form gate spacers. The source/drain area is reopened and the source and drain are doped, as by implantation. An additional dielectric is applied and metal contacts are made to the source and the drain.

Fig. 4 is a schematic cross section of the resulting device. It is similar to a conventional silicon-gate MOS field effect transistor. It has the conventional source, gate, drain, and channel of the Fig. 2 workpiece, a conventional passivating dielectric layer 30 and conventional ohmic contacts 31, 32. It differs from conventional devices. in that thin regions 33, 34 selectively formed at the dielectric/source interface and the dielectric/drain interface are oxynitride rather than oxide. These oxynitride regions are stronger than oxide in resisting damage from electron collisions, producing a more reliable device having a longer operating life.

The invention can be more clearly understood by consideration of the following specific example.

### Example

Using a sub-0.5 µm CMOS test process, N-incorporation was achieved through nitrogen implant into source/drain regions at the lightly doped drain (LDD) implant step incurring no additional mask steps. After the nitrogen implant, an annealing process (LDD push) in a diluted O₂ environment was performed to remove the implant damage. A very thin layer of oxynitride was formed at the corner of the source/drain area and the gate oxide during the annealing process.

Specifically, multiple wafers were processed with a 0.35 µm gate oxide. Nitrogen with an energy of 25 keV was implanted into the source and drain region at the LDD step, up to a total dose of 1x10¹⁴/cm². After the regular LDD implant, the LDD push was processed in either N₂ or 10% of O₂/N₂ at a temperature of 900°C for a period of 25 minutes. Table I shows the split information.

**Table I,**

| Nitrogen Source/Drain implant splits | | | |
|---|---|---|---|
| Splits | Gate oxide thickness (Å) | N implant @ LDD step | Post LDD anneal |
| 1 | 50 | no implant | std |
| 2 | 50 | 25 kev, 1x10¹⁴/cm² | std |
| 3 | 50 | 25 kev, 1x10¹⁴/cm² | 10% 0₂/N₂ |

Table II summarizes defect density D₀, gate oxide leakage, wear out and breakdown characteristics. Specifically, defect density is tabulated for the unpatterned gate oxide (GOX Do) over both p-type tubs (PTB) and n-type tubs (NTB). Also shown are the defect densities for the patterned gate oxides (PGOX D₀). Log (N_{bd}) provides a measure of the total charges which flows through the oxide before breakdown. This is given for both n-channel devices (NTₒₓ) and p-channel devices (PTₒₓ).

**Table II,**

| Electrical Characterization | | | | | | |
|---|---|---|---|---|---|---|
| Splits | GOX D₀ PTB | GOX D₀ NTB | PGOX D₀ PTB | PGOX D₀ NTB | Log (N_{bd}) NTₒₓ | Log (N_{bd}) PTₒₓ |
| 1 | 1.19 | 2.45 | 2.2 | 2.94 | -0.09 | 0.56 |
| 2 | .87 | 1.34 | .83 | 1.72 | -0.07 | 0.51 |
| 3 | .92 | 1.91 | 1.61 | 2.19 | -0.05 | 0.56 |

Since the nitrogen implant was done at the n-LDD step, only the PGOX at P-tub data represent the implant effect. On the GOX area, nitrogen is actually implanted into poly-Si over the whole thin oxide area. For 50 Å PGOX, the defect density (D₀) is 2.2/cm² for controls. However, with nitrogen implant and a normal LDD push, D₀ decreases to 0.83 cm². The defect density was reduced to 1.61/cm² by LDD push in a 10% O₂/N₂ atmosphere.

For further studying the impact of nitrogen implantation and LDD push ambient on gate oxide long term reliability, time dependent dielectric breakdown (TDDB) measurements were performed at a field of 8 MV/cm on one wafer from each split. Results from 50 Å gate oxides are presented in Fig 6. Legends indicate nitrogen implant and annealing ambient (NLdd for 10% O₂/N₂). B-mode failure is extrinsic breakdown indicative of imperfect oxide. The lower, the better. For the standard process, B-mode failure was increased slightly to 10-30% in the range of 100 seconds. With nitrogen LDD implant, B-mode failure was reduced to about 5-10%. From these data, nitrogen implantation improves GOX reliability.

## Claims

1. A method of making a field effect transistor comprising the steps of forming on the surface of a semiconductor substrate a source and a drain separated by a channel and forming a gate overlying said channel, said gate separated from said channel by a layer of dielectric material, and forming contacts to said source gate and drain to produce a field effect transistor, CHARACTERISED IN THAT
prior to forming said contacts, nitrogen is implanted into the source and the drain at a tilt angle and the resulting structure is thermally annealed.

2. The method of claim 1 wherein said tilt angle is in the range of 7° to 45°.

3. The method of claim 1 or claim 2 wherein said layer of dielectric overlies the source and the drain and said nitrogen is implanted with sufficient energy to penetrate through the dielectric.

4. The method of any of the preceding claims wherein said nitrogen is molecular nitrogen.

5. The method of any of the preceding claims wherein said nitrogen is implanted at an energy in the range 5-100 KeV.

6. The method of any of the preceding claims wherein said annealing is at a temperature in the range 800-1000°C.

7. The method of any of the preceding claims wherein said annealing is for a time in the range 10-60 min.

8. The method of any of the preceding claims wherein said nitrogen is implanted at a dose in the range 10¹³ to 10¹⁵/cm².

9. The method of any of the preceding claims wherein said implantation and annealing produces a layer of oxynitride having a thickness in the range 0.3 to 0.5nm.

10. The method of any of the preceding claims wherein said substrate is monocrystalline silicon, said dielectric is silicon and said gate is polycrystalline silicon.

11. The method of any of the preceding claims wherein said annealing is in an atmosphere comprising an inert gas.

12. An insulating gate field effect transistor comprising a source, a gate, a gate insulating layer and a drain formed on a semiconductor surface, said insulating disposed between said gate and said semiconductor surface and said gate overlying a channel region in said semiconductor disposed between said source and said drain, CHARACTERISED IN THAT
portions of said gate insulator in the regions adjacent said source and said drain comprise layers of oxynitride.

13. The transistor of claim 12 wherein said oxynitride layers have a thickness in the range 0.3 - 0.5 nm.

14. The transistor of claim 12 or claim 13 wherein said semiconductor surface comprises a silicon surface, said gate comprises polycrystalline silicon. and said insulating layer comprises silicon oxide.

15. The transistor of any of claims 12 to 14 wherein said oxynitride layers have a width in the range 5 to 50 nm.
